# EUROPEAN PATENT SPECIFICATION

(11) **EP 0 840 299 B1**
(45) Date of publication and mention of the grant of the patent: **01.03.2006**
(21) Application number: 97118007.0
(22) Date of filing: 17.10.1997
(51) Int. Cl.: G11B 7/09, G11B 21/10

(54) **Input signal amplifier**
Eingangssignalverstärker
Amplificateur de signal d'entrée

(30) Priority: 30.10.1996 DE 19644996
(43) Date of publication of application: 06.05.1998
(73) Proprietor: DEUTSCHE THOMSON-BRANDT GMBH, 78048 Villingen-Schwenningen (DE)
(72) Inventor: Zucker, Friedhelm, 78052 Villingen-Schwenningen (DE); Baas, Reiner, 77790 Steinach (DE); Büchler, Christian, 78052 Villingen-Schwenningen (DE)
(74) Representative: Wördemann, Hermes

(56) References cited:
- GB-A- 2 275 795
- US-A- 5 089 757

## Description

The invention relates to an input signal amplifier, preferably of a reproduction or recording device for optical recording media, such as, for example, an input signal amplifier for tracking or focusing in servo control loops of recording or reproduction devices of optical recording media.

In reproduction devices and likewise in recording devices for optical recording media, the recording medium is irradiated with a light source, for example a laser, and the light reflected from the recording medium is fed to a photodetector comprising a plurality of photovoltaic cells. The photodetector generates both the information signal, which is stored, if appropriate, on the recording medium, and error signals for tracking and for focusing of the light beam, which signals are fed to input amplifiers. Since production dictates that optical recording media will have a different reflectivity, lasers will have a different light intensity and photodetectors will have a different sensitivity, control deviations in particular are represented by different signal intensities. Without appropriate measures, a connected control loop for a specific control deviation would be driven by different signals, as a result of which the control response is influenced in a disadvantageous manner.

In order, despite the abovementioned deviations, to ensure uniform scaling of control deviations, it is already known to use analog dividers or A/D converters and a pulse width control arrangement, controlled by a microprocessor, with subsequent low-pass filtering. In principle, these means alter the input signal gain for uniform scaling. In order to control the gain, the input signal itself is used in this case.

However, analog divider circuits are expensive, require adjustment and are inaccurate owing to the generation of an offset. Furthermore, the known circuits are sensitive to temperature, with the result that temperature stability is not attained, which is disadvantageous particularly for portable devices.

An input signal amplifier with a feedback network controlled by an A/D converter to improve the dynamic range of the A/D converter already has been disclosed in GB-A-2 2745 795.

The invention is based on the object, therefore, of providing a circuit in which the gain of an input signal amplifier, such as, for example, the gain of the tracking error signal and/or focus error signal, can be regulated in a simple and accurate manner for uniform scaling.

The object is achieved by means of the features respectively specified in an independent claim. Further refinements of the invention are specified in subclaims.

The present invention relates to a circuit for controlling the gain of an input signal amplifier, such as, for example, an input signal amplifier for servo control loops of a recording or reproduction device for optical recording media, in which a summation signal of the optical scanning unit is fed to an A/D converter and the resulting digital summation signal is used to control the gain of the input signal amplifier. The input signal amplifier is thereby controlled digitally. The digital summation signal influences the feedback of the input signal amplifier and, as a result, its gain. This is achieved by virtue of the fact that the bits which represent the value of the digital summation signal control the switching in and out of a corresponding feedback resistor of the input signal amplifier.

A switch, which is arranged, for example, in series with the corresponding feedback resistor, is advantageously controlled by each bit of the digital summation signal. A parallel circuit formed by a plurality of these series circuits then forms a feedback network for controlling the gain of the input signal amplifier.

The MSB of the digital summation signal preferably controls the smallest feedback resistor, while the LSB switches the largest feedback resistor in and out. From the MSB to the LSB, the feedback resistors form an ascending sequence in terms of their value, adjacent resistors in the sequence advantageously differing from one another by a factor of 2; in other words the resistor sequence from MSB to LSB has the form R, 2R, 4R, 8R, 16R, ..., where R is the resistance of the smallest resistor.

Furthermore, an additional feedback resistor, which represents the highest power of two of the sequence, is permanently connected as a feedback resistor, for the purpose of limiting the gain of the input signal amplifier. If, therefore, the resistor sequence has n elements, then the additional feedback resistor has the value 2ⁿ · R.

The A/D converter for digitizing the summation signal is controlled by the clock signal in a known manner.

The effect advantageously achieved by the gradation of the resistors into powers of two is that the gain of the input signal amplifier is altered reciprocally relative to the input signal, as is required for correct operation of the servo control loop. In other words, if, for example, the summation signal of the four photodetectors of a four-quadrant detector of the optical scanning element is doubled, then the digitized summation value is likewise doubled. As a result of the gradation of the resistors, the conductance is likewise doubled, and since the conductance in the feedback of the corresponding amplifier is doubled, the gain is consequently halved. The total conductance of the feedback is proportional to the input voltage in an analog gradation. The clock signal used for the summation signal A/D converter is provided by a microprocessor or oscillator. The clock signal must be fast enough to enable the gain control to be regulated sufficiently rapidly if an intensity change occurs in the summation signal. If error locations appear on the optical recording medium, it is possible, wherever it is practical, to hold the set gain value by blocking the clock signal in dependence on the error detectors. This makes it possible to dispense with holding elements in the circuit. The clock signal is suppressed in order to avoid unnecessary or grossly incorrect settings when errors occur. Overall, the circuit according to the invention has a simple structure and there is no need to compensate for any offset. Calibration is unnecessary on account of the digital control.

In accordance with a second design, the feedback network is a series circuit of resistors, each resistor having, except for the smallest one, a switch connected in parallel with it. Furthermore, the feedback network can also be realized using a combination of series and parallel circuits of resistors and switches.

The invention is explained in more detail below with reference to exemplary embodiments in drawings.

In the Figures:
Figure 1 shows a circuit diagram of an input signal amplifier with a first feedback network and
Figure 2 shows a circuit diagram of an input signal amplifier with a second feedback network.

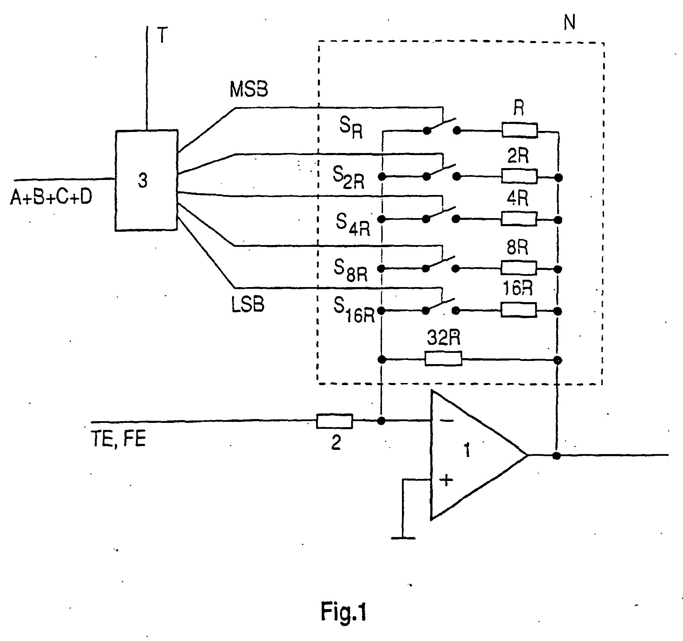

Figure 1 shows an input signal amplifier, which is an error signal amplifier 1 designed as a differential amplifier, to the first input of which the error signal, for example the focus error signal FE or the tracking error signal TE, is applied via a resistor 2. In the circuit diagram, the second input of the amplifier 1 is connected to earth or frame ground. The amplified, uniformly scaled error signal is provided at the output of the error signal amplifier 1. A series of resistors R, 2R, 4R, 8R, 16R, 32R are connected in parallel in the feedback path of the amplifier, it being possible to switch the series of resistors R to 16R into and out of the feedback by means of corresponding switches S_{R} to S_{16R}. The circuit furthermore has an A/D converter 3, to the input of which the summation signal of the photodetector, in the present case A + B + C + D on account of the use of a four-quadrant sensor (not illustrated), is applied. After the A/D converter 3, the summation signal is present in digital form. The MSB controls a switch S_{R} with the smallest resistor, that is to say the highest conductivity, while the LSB is connected to the on-off switch S_{16R} of the resistor 16R having the highest value. The individual bits of the digitized summation signal act on the controllable switches S_{R} to S_{16R}, with the result that the switches are switched or not switched depending on the bit. Corresponding selection of the value of the resistors S_{R} - S_{16R}, where two successive resistors differ by a factor of 2, ensures that the gain of the error signal amplifier 1 is reciprocal to the error signal. If, for example, the error signal is doubled on account of a higher reflectivity of the recording medium, then the conductivity is doubled and the gain is thus halved. The A/D converter 3 is controlled by a clock signal T, with the result that the reaction rapidity of the gain adaptation can be regulated externally by way of the clock signal T. In the case of greater interference such as drop-outs, the clock can be stopped and, on account of this, the gain can be maintained corresponding to the position of the switch S_{R} - S_{16R}. The necessity of sample-and-hold circuits is thereby rendered superfluous.

It is advantageous to provide a resistor 32R permanently in the feedback network N of the amplifier 1, since when all the switches are open, that is to say no summation signal is present, the gain tends to infinity. The resistor 32R ensures that the amplifier retains a minimal gain. Furthermore, matching this resistor to the resistor sequence, that is to say the resistor 32R likewise has twice the value of its neighbour 16R, ensures that an error originating from component tolerances or a setting of the feedback network is equal to half the error of the last stage.

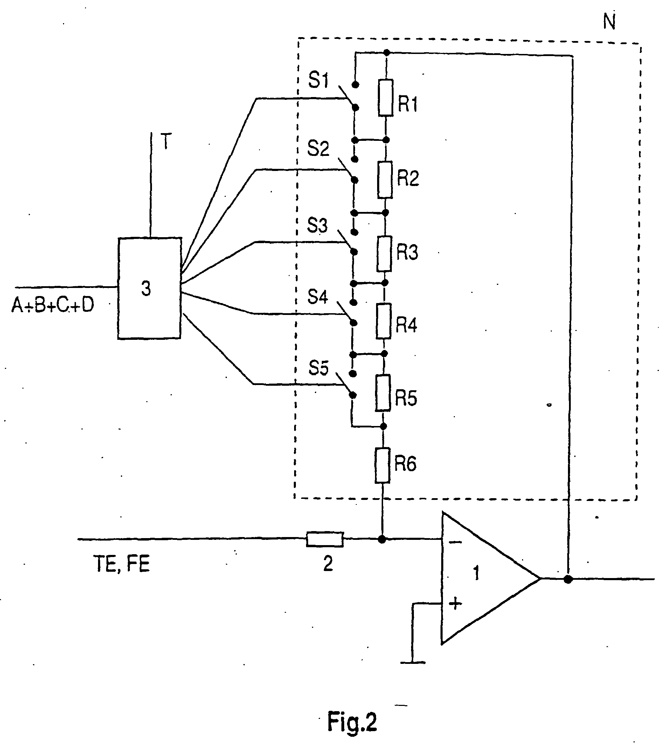

In a second design in accordance with Figure 2, a second feedback network N is provided, which is essentially formed by a series circuit of resistors R1 to R6. The series circuit of resistors R1 to R6 is provided in the feedback path of the input signal amplifier 1 and a respective switch S1 to S5 is connected in parallel with the resistors R1 to R5. The switches S1 ... S5 are driven by the A/D converter 3 in a manner analogous to the first exemplary embodiment. The arrangements in accordance with Figure 1 and Figure 2 differ exclusively in the type of feedback network N. The feedback network N can also be constructed using a feedback circuit other than the one illustrated in the exemplary embodiments, with corresponding driving by means of an A/D converter. The only precondition for the functionality of the circuit arrangement is that the gain of the input signal amplifier 1 is changed by means of the output signal of the A/D converter 3 reciprocally relative to the summation signal A + B + C + D, in order to ensure uniform stabilization of the error signals FE, TE. The gain of the input signal amplifier 1 is controlled digitally. That is to say an input signal amplifier 1 which amplifies analog signals has digital gain setting. Since the A/D converter 3 is clocked, it is furthermore possible, with a corresponding clock control, to avoid unnecessary or grossly incorrect settings when errors of the optical recording medium occur.

It should be mentioned that the invention is not restricted to the abovementioned exemplary embodiments, since, in principle, it can be used for the uniform scaling of error signals which fluctuate in terms of their intensity.

## Claims

1. Circuit arrangement comprising an input signal amplifier (1) with a feedback network (N) controlled by an A/D converter (3) and a photodetector, wherein an input of said input signal amplifier (1) is connected to said photodetector
**characterized in that**
the input signal applied to said input signal amplifier (1) is a focus error signal or a tracking error signal provided by said photodetector and said photodetector provides a summation signal to the A/D converter (3) which controls the feedback network (N).

2. Circuit arrangement according to Claim 1 wherein the feedback network (N) is a controllable resistor.

3. Circuit arrangement according to claim 1 wherein the A/D converter (3) of the summation signal is clocked by means of a clock signal (T).

4. Circuit arrangement according to one of the preceding claims wherein a control means is provided for controlling the clock signal (T) of the A/D converter (3) as a function of a signal detected from the recording medium.

## Revendications

1. Configuration de circuit comportant un amplificateur de signal d'entrée (1) avec un réseau de réaction (N) commandé par un convertisseur A/N (3) et un photodétecteur, dans laquelle une entrée dudit amplificateur de signal d'entrée (1) est reliée audit photdétecteur
**caractérisée en ce que**
le signal d'entrée appliqué audit amplificateur de signal d'entrée (1) est un signal d'erreur de focalisation ou un signal d'erreur de suivi de piste généré par ledit photodétecteur et ledit photodétecteur applique au convertisseur A/N (3) un signal de sommation qui commande le réseau de réaction (N).

2. Configuration de circuit selon la revendication 1, dans laquelle le réseau de réaction (N) est une résistance dont la valeur peut être commandée.

3. Configuration de circuit selon la revendication 1, dans laquelle le convertisseur A/N (3) du signal de sommation est synchronisé à l'aide d'un signal d'horloge (T).

4. Configuration de circuit selon la revendication 1, selon l'une des revendications précédentes, dans laquelle il est prévu un moyen de commande du signal d'horloge (T) du convertisseur A/N (3) en fonction d'un signal détecté sur le support d'enregistrement.

## Patentansprüche

1. Schaltungsanordnung, umfassend einen Eingangssignalverstärker (1) mit einem von einem A/D-Wandler (3) und einem Photodetektor gesteuerten Rückkopplungsnetzwerk (N), wobei ein Eingang des Eingangssignalverstärkers (1) mit dem Photodetektor verbunden ist, **dadurch gekennzeichnet, dass** das dem Eingangssignalverstärker (1) zugeführte Eingangssignal ein von dem Photodetektor geliefertes Fokus-Fehlersignal oder ein Spurfolge-Fehlersignal ist und der Photodetektor an den A/D-Wandler (3) ein Summensignal liefert, das das Rückkopplungsnetzwerk (N) steuert.

2. Schaltungsanordnung nach Anspruch 1, bei der das Rückkopplungsnetzwerk (N) ein steuerbarer Widerstand ist.

3. Schaltungsanordnung nach Anspruch 1, bei der der A/D-Wandler (3) des Summensignals mittels eines Taktsignals (T) getaktet wird.

4. Schaltungsanordnung nach einem der vorhergehenden Ansprüche, bei der ein Steuermittel zur Steuerung des Taktsignals (T) des A/D-Wandlers (3) als Funktion eines aus dem Aufzeichnungsträger festgestellten Signals vorgesehen ist.
